(19) Europäisches Patentamt
European Patent Office
Office européen des brevets

(11) Veröffentlichungsnummer: **0 238 082**
**A2**

(12) **EUROPÄISCHE PATENTANMELDUNG**

(21) Anmeldenummer: **87104030.9**

(51) Int. Cl.[4]: **H01L 31/14** , G02B 6/42

(22) Anmeldetag: **19.03.87**

(30) Priorität: **19.03.86 DE 3609278**

(43) Veröffentlichungstag der Anmeldung:
**23.09.87 Patentblatt 87/39**

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **Kappeler, Franz, Dr.-Ing.**
**Narzissenstrasse 4**
**D-8039 Puchheim(DE)**
Erfinder: **Stegmüller, Bernhard, Dr.-Ing.**
**Seefelderstrasse 18**
**D-8900 Augsburg(DE)**

(54) **Integrierte optische Halbleiteranordnung.**

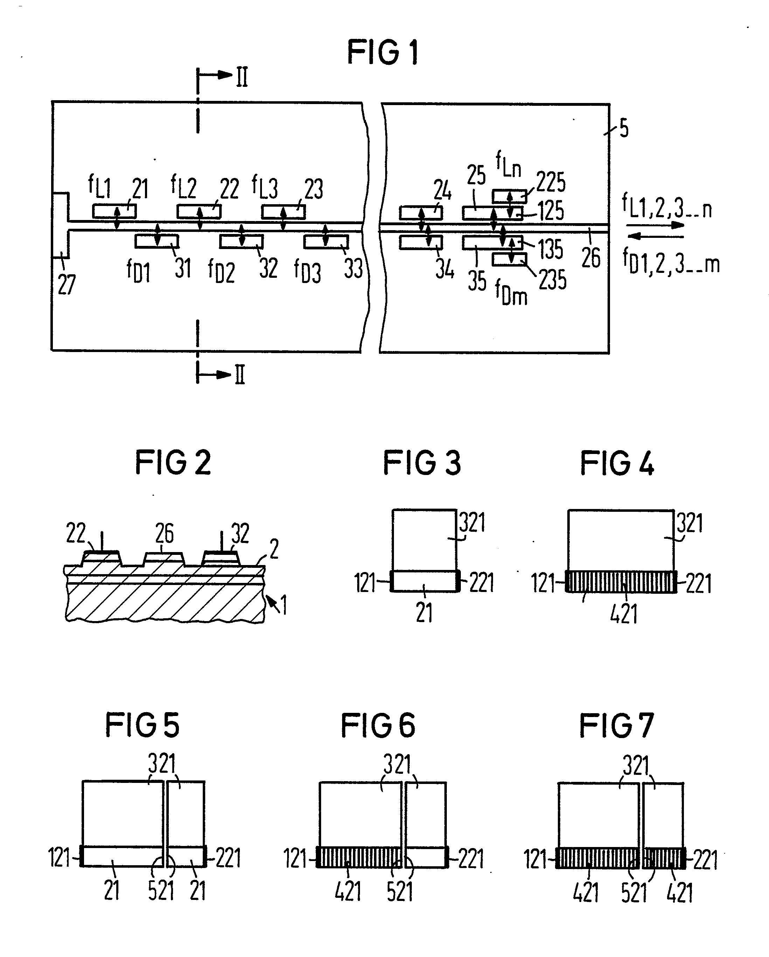

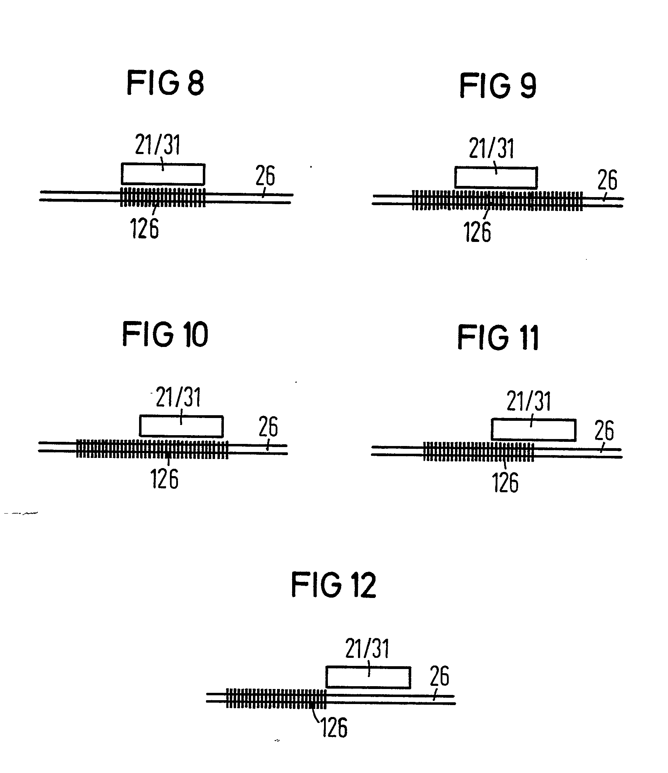

(57) Integrierte Frequenzmultiplex-Anordnung für optische Nachrichtenübertragung. Auf einem Substratkörper (2) sind jeweils mehrere frequenzselektiv aufgebaute (Fig. 3 bis 7) Sender (21, 22 ...) und/oder Empfänger (31, 32 ...) benachbart dem Wellenleiter - (26) angeordnet, der ebenfalls örtlich mit Selektivität ausgestattet sein kann (Fig. 8 bis 12).

FIG 1

II
5
fL1
21
fL2
22
fL3
23
24
25
fLn
225
125
fL1,2,3--n
27
fD1
31
fD2
32
fD3
33
34
35
fDm
135
235
26
fD1,2,3--m
II

EP 0 238 082 A2

Xerox Copy Centre

# Integrierte optische Halbleiteranordnung

Die vorliegende Erfindung bezieht sich auf eine integrierte optische Halbleiteranordnung gemäß den Merkmalen des Oberbegriffes des Patentanspruches 1.

Es ist bekannt, in der Nachrichtentechnik optische Lichtwellenleiter (Glasfasern) als Leitung bzw. Kabel für die Nachrichtenübertragung zu verwenden. Wegen der für derartige Nachrichtenübertragung zur Verfügung stehenden relativ großen Übertragungsbandbreite derartiger Lichtwellenleiter ist es zweckmäßig, einzelne Signalkanäle entsprechend den an sich bekannten Prinzipien der Trägerfrequenz-Nachrichtentechnik auf mehrere optische Trägerfrequenzen aufzuteilen und diese modulierten Trägerfrequenzen zu übertragen. Für ein solches Frequenzmultiplex-Verfahren benötigt man elektrooptische Sendeeinrichtungen und Empfangseinrichtungen, mit denen mehrere dicht nebeneinander liegende Trägerfrequenzen erzeugt und moduliert werden können bzw. empfangen und demoduliert werden können. Solche Einrichtungen sollten es ermöglichen, möglichst verlustfrei die Sende-Lichtwellen in den gemeinsamen Wellenleiter einzukoppeln und das empfangene Gesamtsignal auszukoppeln, durch Filtern in die einzelnen Kanäle aufzuteilen und das Empfangssignal zu gewinnen.

Vorzugsweise sollte eine solche Sendeeinrichtung und eine solche Empfangseinrichtung als integrierte elektrooptische "Schaltung" ausgeführt sein, wobei insbesondere die Sendeeinrichtung und die Empfangseinrichtung miteinander integriert aufgebaut sein sollten.

Es ist bekannt, zur Erzeugung der Trägerfrequenzen, deren Frequenzen sich entsprechend einem vorgegebenen engen Kanalraster relativ wenig voneinander unterscheiden, einfrequente, monomodige Laserstrahlungsquellen bzw. Laserdioden zu verwenden. Bevorzugt ist der Frequenzbereich, der (Luft-)Wellenlängen zwischen 1,3 und 1,6 µm entspricht. Ein solcher Frequenzbereich ist deshalb bevorzugt, weil für diesen Frequenzbereich Glasfaserleitungen (für bestimmte Moden) sehr günstige Übertragungseigenschaften haben und Halbleiter-Laserdioden, -Fotodetektoren, -Modulatoren und -Filter nach bereits wenigstens weitgehend bekannten Prinzipien hergestellt werden können und miteinander auch integrierbar sind. Zum Beispiel sind für diesen Frequenzbereich Laserdioden herstellbar, die sowohl im statischen als auch im dynamischen Betrieb, insbesondere bei direkter Modulation mittels einer Modulation des Betriebsstromes hohe Frequenzstabilität aufweisen und die außerdem hinsichtlich ihrer Frequenz elektronisch abstimmbar sind.

Zur Trennung und Demodulation der optischen Eingangssignale werden frequenzselektive Detektoren benötigt, deren Detektionsbandbreite entsprechend schmal gegenüber dem Kanalraster ist. Eine integrierte Sende-und/oder Empfangseinrichtung sollte möglichst platzsparend auf einem einzigen Halbleitersubstrat integriert sein, womit unter anderem auch kostengünstige Herstellung verbunden ist.

Bekannte Lösungsansätze für derartige Einrichtungen bzw. Frequenzmultiplex-Schaltungen haben eine Anzahl Laserdioden-Strukturen mit verteilter Rückkopplung (sog. DFB-und DBR-Laser), wobei diese Strukturen auf einem für solche Laserdioden bekanntermaßen verwendeten Halbleiter substrat nebeneinanderliegend angeordnet sind. Es ist bekannt, die (Träger-)Frequenz der in einer solchen Halbleiter-Laserdiode erzeugten Laserstrahlung durch entsprechende Dimensionierung einzustellen. So läßt sich z.B. bei einer Laserdiode mit einem DFB-Gitter (distributed feed back), das Resonanzeigenschaft bewirkt, die Laserstrahlungsfrequenz durch Wahl der Gitterperiode einstellen. Es lassen sich damit Laserstrahlungs-Frequenzen einstellen, die einen Frequenzabstand von nur 500 GHz (ca. 3 nm Wellenlängenunterschied) aufweisen.

Lösungsansätze für das Ein-bzw. Auskoppeln in bzw. aus der Glasfaserleitung sehen passive Mehrfachbandpässe (Multiplexer bzw. Demultiplexer) vor, die über Wellenleiter, die eine Länge von einigen Millimetern haben, mit den Laserdioden bzw. Fotodetektoren verbunden sind. Die technischen Möglichkeiten für die Realisierung derartiger Bandpässe setzen eine Grenze für die minimale Durchlaßbandbreite dieser Bandpässe, die erheblich größer ist, als der Frequenzabstand der Trägerfrequenzen, die entsprechend den obigen Darlegungen technisch realisierbar sind. Der minimale Kanalabstand für ein solches Übertragungssystem ist somit durch die minimale realisierbare Bandbreite derartiger passiver Bandfilter begrenzt.

Die Abmessungen einer Schaltung nach den vorangehend beschriebenen Lösungsvorschlägen sind im wesentlichen durch den Platzbedarf für den Multiplexer und den Demultiplexer sowie durch die erforderlichen Verbindungs-Wellenleiter bestimmt. Solche Abmessungen liegen im Zentimeter-Bereich, was bedeutet, daß ein derartiges Prinzip in integrierter Halbleitertechnologie zumindest nur - schwierig zu realisieren wäre.

Es ist eine Aufgabe der vorliegenden Erfindung, Maßnahmen anzugeben, mit denen oben erörterte Probleme behoben sind, insbesondere solche Einrichtungen in integrierter Halbleitertechnologie herstellbar sind.

Diese Aufgabe wird mit einer integrierten optischen Halbleiteranordnung gelöst, die die Merkmale des Patentanspruches 1 aufweist und weitere Ausgestaltungen und Weiterbildungen der Erfindung gehen aus den Unteransprüchen hervor.

Eine erfindungsgemäße Halbleiteranordnung umfaßt einfrequente, monomodige Halbleiterlaser, die auf voneinander verschiedene Sendefrequenzen bzw. Frequenzen der von ihnen erzeugten Laserstrahlung abgestimmt sind und/oder frequenzselektive Fotodetektoren, deren Selektionsfrequenz (-bereich) auf jeweilige vorgegebene Trägerfrequenzen abgestimmt sind. Außerdem umfaßt eine erfindungsgemäße Halbleiteranordnung einen Wellenleiter mit dem solche Halbleiterlaser und/oder solche Fotodetektoren aufgrund der Anordnung zueinander optisch gekoppelt sind. Die erwähnten Laserdioden und Fotodetektoren sind generell optische Resonatorstrukturen, zu denen Elektroden zugeordnet sind, wie sie für elektrooptische Bauelemente bekanntermaßen verwendet werden. Im allgemeinen ist als die eine Elektrode ein Substratkontakt und für die andere Elektrode eine streifenförmige Oberflächenbelegung des Halbleiterkörpers vorgesehen.

Insbesondere mit Rücksicht auf die Laserdioden ist eine solche erfindungsgemäße Halbleiteranordnung in einem Halbleiterkörper realisiert, der auf einem Halbleitersubstrat eine solche Schichtstruktur, z.B. eine Doppel-Heteroschichtstruktur besitzt, die vorzugsweise epitaktisch abgeschieden ist.

Der vorgesehene optische Wellenleiter ist in dem Halbleiterkörper ein streifenförmiger Bereich, dessen Streifenform dadurch erkennbar ist, daß seitlich des Streifens, d.h. quer zum Streifen gesehen, ein Brechungsindexunterschied auftritt, wie er bekanntermaßen für wellenoptische Führung bei z.B. Laserdioden vorgesehen ist.

Die Resonatorstrukturen haben eine ausgeprägte Longitudinalausrichtung. Der Wellenleiter hat eine Längsrichtung entsprechend der Streifenform. Es sei darauf hingewiesen, daß der Streifen des Wellenleiters nicht notwendigerweise geradlinig sein muß, jedoch vorzugsweise geradlinig gewählt wird. Die Longitudinalausrichtung der jeweiligen Resonatorstruktur (für Sender und/oder für Empfänger) wird wenigstens im wesentlichen parallel zur jeweiligen örtlichen Längsrichtung des Wellenleiters orientiert und der Abstand der jeweiligen Resonatorstruktur vom Wellenleiter ist so bemessen, daß vorgegebene bzw. ausreichende gegenseitige laterale wellenoptische Kopplung zwischen Wellenleiter und jeweiliger Resonatorstruktur besteht.

Zu einer erfindungsgemäßen Halbleiteranordnung gehören zu einem Wellenleiter eine der Anzahl der vorgegebenen Trägerfrequenzen entsprechende Anzahl Sende-Resonatorstrukturen und/oder eine entsprechende Anzahl Empfangs-Resonatorstrukturen. Eine einzelne Resonatorstruktur besteht in allgemeinster Ausführung aus einem einzigen Longitudinalstreifen mit die Resonanzeigenschaft bewirkenden Mitteln. Eine einzelne Resonatorstruktur kann aber auch aus mehreren, insbesondere aus zwei zueinander im wesentlichen parallel orientierten, im Abstand voneinander liegenden Strukturen bestehen.

Eine weitere Ausführungsform einer erfindungsgemäßen Halb leiteranordnung kann auch so ausgebildet sein, daß der Wellenleiter örtlich über seine Länge verteilt zu einem jeweiligen Resonator ausgebildet ist, wobei der Ort für einen solchen Resonator so gewählt ist, daß dieser Resonator im wesentlichen neben einer Resonatorstruktur liegt, deren Resonanzfrequenz gleich der Resonanzfrequenz des Resonators ist.

Weitere Erläuterungen der Erfindung gehen aus der nachfolgenden anhand der Figuren gegebenen Beschreibung hervor.

Figur 1 zeigt die Aufsicht auf eine erfindungsgemäße integrierte optische Halbleiteranordnung, und zwar mit einer Variante einer optischen Resonatorstruktur, die aus zwei parallelen Strukturen besteht.

Figur 2 zeigt die Ansicht des Schnittes II-II in Figur 1.

Die Figuren 3 bis 7 zeigen einzelne Ausführungsformen für Resonatorstrukturen einer erfindungsgemäßen Halbleiteranordnung, und zwar in der Aufsicht entsprechend der Figur 1.

Die Figuren 8 bis 12 zeigen Ausführungsformen für Resonatoren des Wellenleiters.

Die Halbleiteranordnung 1 ist auf bzw. in einem Halbleiterkörper 2 ausgeführt, der z.B. aus einem Halbleitersubstrat 3 und einer Schichtstruktur 4, z.B. einer Doppelheteroschichtstruktur solcher Art, wie sie für Laserdioden verwendet wird. Mit 21 bis 25 und 31 bis 35 sind optische Resonatorstrukturen bezeichnet, die in Figur 1 ganz allgemein gültig dargestellt sind. Zum Beispiel sind die Resonatorstrukturen 21 bis 25 einzelne Laserdioden-Anordnungen. Die Resonatorstrukturen 31 bis 35 sind beispielsweise Detektoranordnungen. Ein jeweiliger Aufbau bzw. eine jeweilige Ausgestaltung solcher Resonatorstrukturen kann untereinander einheitlich sein, kann aber auch unterschiedlich gewählt sein. Ausführungsbeispiele für solche Resonatorstrukturen zeigen die Figuren 3 bis 7. Wie aus der Figur 1 ersichtlich ist, haben diese Resonatorstrukturen eine Longitudinalausrichtung, die in der Figur 1 der Richtung der Horizontalen entspricht.

Mit 26 ist ein Wellenleiter bezeichnet, der im Ausführungsbeispiel der Figur 1 die bevorzugte Form eines geradlinigen Streifens hat. Dementsprechend ist auch die örtliche Längsrichtung des Wellenleiters überall einheitlich und entspricht der Horizontalen der Darstellung der Figur 1.

Mit den in Figur 1 eingetragenen Doppelpfeilen ist auf vorhandene gegenseitige laterale wellenoptische Kopplung hingewiesen.

Die soweit dargestellte Ausführungsform nach Figur 1 kann als Durchgangs-Anordnung verwendet werden. Es kann aber auch nur Aussendung und Empfang auf einer Stirnseite 5 des Halbleiterkörpers 2 vorgesehen sein.

Mit 27 ist lediglich schematisch ein sonstiger Fotodetektor bezeichnet, der z.B. breitbandig ist und z.B. vorgegebenen Steuerungsmaßnahmen dient.

Mit 25 und 35 sind spezielle Ausgestaltungen einer optischen Resonatorstruktur der Erfindung bezeichnet. Es handelt sich bei einer Resonatorstruktur 25 bzw. 35 um eine Doppelstruktur, die aus zwei (wiederum parallelen) Strukturen 125 und 225 besteht. Als Laserdiode ist eine solche Doppelstruktur hinsichtlich ihres speziellen Aufbaues, ihrer Eigenschaften und ihres Verwendungszweckes ins Einzelne gehend in der europäischen Offenlegungsschrift (84/1017) beschrieben. Eine solche Doppelstruktur liefert besonders stabil monomodige Laserstrahlung, die in die Wellenleitung 26 einzukoppeln ist. Der Aufbau einer Doppelstruktur 35 entspricht demjenigen einer Doppelstruktur 25. Als Detektor 35 besteht ein Unterschied in der Betriebsweise. Während die Strukturen 125 und 225 der Doppelstruktur 25 derart mit Strom gespeist werden, daß bei vorliegender gegenseitiger wellenoptischer Kopplung Laserstrahlungserzeugung in der Struktur 125 auftritt, ist für die Strukturen 135 und 235 eine solche Stromspeisung vorgesehen, bei der auch bei maximaler Einkopplung einer optischen Welle aus dem Wellenleiter 26 in die Doppelstruktur 35 dort noch keine - (einem Sender entsprechende) Selbsterregung auftritt, sondern lediglich durch auftretende Verstärkung ein verstärktes (selektives) Detektorsignal zu empfangen ist. Die Struktur 135 ist in diesem Sinne ein aktives Filter und die Struktur 225 unter anderem der Fotodetektor.

Eine optische Resonatorstruktur 21 bis 25 bzw. 31 bis 35 kann als Sender betrieben werden, wenn sie als Laserstruktur in Flußrichtung des Dioden-Aufbaues der Schichtstruktur 4 von einem Strom mit oberhalb des Schwellenwertes liegender Stromstärke durchflossen wird. Der Betrieb als Empfänger erfolgt mit in Sperrichtung der Diodenstruktur der Schichtstruktur 4 angelegter elektrischer Spannung, nämlich wie für Fotodioden üblich.

Die einzelnen optischen Resonatorstrukturen 21 bis 25 bzw. 31 bis 35 sind so ausgeführt, daß in longitudinaler (in der Figur horizontaler) Richtung keine Wellenkopplung von einer Resonatorstruktur zu einer anderen Resonatorstruktur erfolgt. Im Regelfall ist dies durch entsprechenden üblichen Aufbau der einzelnen optischen Resonatorstrukturen gewährleistet. Die (Resonator-)Länge einer einzelnen optischen Resonatorstruktur 21 bis 25 bzw. 31 bis 35 kann in für Laserdioden geeignetem Halbleitermaterial relativ klein sein (z.B. kleiner als 100 µm lang). Angestrebt ist möglichst hohe Resonatorgüte der einzelnen Resonatorstruktur, was z.B. durch entsprechend hohen Reflexionsgrad der Reflektoranordnungen der jeweiligen Resonatorstruktur zu erreichen ist. Hohe Güte ergibt nicht nur hohe Selektivität, sondern auch starke Überkopplung des in einer als Sender betriebenen Resonatorstruktur erzeugten Laserstrahlung, und zwar in den benachbart verlaufenden Wellenleiter 26.

Figur 3 zeigt eine einfache Ausführungsform einer der optischen Resonatorstrukturen 21 (bis 25 bzw. 31 bis 35). Mit 121 und 221 ist je ein spiegelnder Reflektor bezeichnet. Ein solcher Reflektor 121, 221 kann in der wie in der obengenannten europäischen Offenlegungsschrift beschriebenen Art ausgeführt sein, wobei die Spiegelfläche eine Stirnfläche einer in die Oberfläche des Halbleiterkörpers 2 eingeätzten Grube ist. Als solche reflektierende Fläche kann eine dielektrische Mehrschichtenanordnung oder (unter Wahrung der notwendigen elektrischen Isolation) eine Metallschicht sein. Eine solche optische Resonatorstruktur ist seit langem als Fabry-Perrot-Resonator bekannt. Mit 321 ist eine Kontaktierungsbelegung der Oberfläche des Halbleiterkörpers 2 bezeichnet. Diese (in Figur 1 nicht dargestellte) Oberflächenbelegung 321 erstreckt sich auch über die (der Darstellungsebene der Figur 3 entsprechende) Oberfläche der optischen Resonatorstruktur 21 und bildet eine für Laserdioden an sich bekanntermaßen verwendete Elektrode.

Die Breite einer optischen Resonatorstruktur 21 liegt etwa zwischen 1 µm und 20 µm. Diese Breite ergibt sich aus entsprechender Strukturierung des Halbleitermaterials in einem Bereich einer solchen Breite und einer Länge des Abstandes der Reflektoren 121 und 221 voneinander.

Figur 4 zeigt schematisch eine andere Ausführungsform einer optischen Resonatorstruktur 21, nämlich mit einer DFB-(Streifen-)Struktur, die als verteilter Reflektor (distributed) bekanntermaßen wirksam ist. Die Resonanzfrequenz ist bekanntermaßen durch Bemessung der Gitterstruktur 421 vorgebbar. Zur Verstärkung der Resonatorwirkung dieser Resonatorstruktur nach Figur 4 sind zusätzlich noch die schon beschriebenen Spiegel 121 und 221 vorgesehen. Aus der Frequenzselektion der Gitterstruktur 421 und der Resonatorwirkung der Reflektoren 121 und 221 ergibt sich die Gesamtresonatorwirkung der Ausführungsform nach Figur 4. Mit 321 ist wiederum der schon zur Figur 3 beschriebene elektrische Kontakt bezeichnet. Auch für die Ausführungsform nach Figur 4 gilt das zur Figur 3 hinsichtlich der Breite einer solchen optischen Resonatorstruktur Angegebene.

Figur 5 zeigt eine optische Resonatorstruktur 21 (bis 25 bzw. 31 bis 35), die aus zwei axial in Reihe hintereinander angeordneten Strukturen nach Figur 3 besteht, wobei Reflektoren 121 und 221 wie dargestellt vorgesehen sind. Ein weniger großes Maß an Reflexion haben die mit 521 bezeichneten Flächen. Wegen der unterschiedlichen Länge der beiden dargestellten Anteile einer Resonatorstruktur nach Figur 5 ergibt sich eine höhere Selektivität bzw. bessere Monomodeneigenschaft für die erzeugte Laserstrahlung, wie dies prinzipiell für derartige Doppelresonatoren bekannt ist.

Figur 6 zeigt einen Doppelresonator, bestehend aus einem der Figur 3 entsprechenden Anteil und einem der Figur 4 entsprechenden Anteil. Beide Anteile sind wie bei der Ausführungsform nach Figur 5 axial hintereinanderliegend angeordnet. Auch eine Ausführungsform nach Figur 6 hat besonders hohe Selektivität bzw. Monomoden-Eigenschaft wie eine Ausführungsform nach Figur 5.

Figur 7 zeigt eine Ausführungsform bestehend aus zwei Anteilen, die jeder eine Ausführungsform nach Figur 4 entsprechen. Fakultativ und in Figur 7 dargestellt hat auch diese Ausführungsform nach Figur 7 zusätzliche Reflektorflächen 121 und 221 am jeweiligen Ende der Resonatorstruktur. Die vorteilhaften Eigenschaften auch der Figur 7 sind an sich bekannt, nämlich hohe Selektivität und hohe Stabilität für Monomoden-Betrieb.

Diese Ausführungsformen nach den Figuren 3 bis 7 sind (wie schon darauf hingewiesen) auch als Verstärker bzw. Detektoren zu verwenden, nämlich bei vergleichsweise zum Laserbetrieb entsprechend geringerer Stromeinspeisung, so daß keine Selbsterregung bei stärkster Strahlungseinkopplung aus dem Wellenleiter 26 erfolgt, bzw. bei Anlegen der Betriebsspannung in Sperrichtung.

Die Figuren 8 bis 12 zeigen Ausführungsformen einer örtlich begrenzten Resonatorausführung hinsichtlich des Wellenleiters 26. Für eine solche Resonatorausführung eignet sich bevorzugt eine z.B. im Zusammenhang mit der Figur 4 bereits beschriebene Streifenstruktur 126 - (in Figur 4 mit 421 bezeichnet). Wie die Figuren 8 bis 12 zeigen, kann eine solche Resonatorausführung 126, und zwar bezogen auf die Länge einer Resonatorstruktur 21/31 unterschiedlich lang und dieser Resonatorstruktur gegenüber verschieden weit axial verschoben angeordnet sein. Eine solche Resonatorausführung 126 dient vorzugsweise weiterer Verbesserung der Selektivität. Je nach Lage und Länge einer solchen Resonatorausführung 126 ergibt sich ein höherer Grad an lateraler wellenoptischer Kopplung zwischen der Resonatorstruktur 21/31 und der Resonatorausführung 126 bzw. mehr oder weniger starke unidirektionale Strahlung im Wellenleiter 26 - (insbesondere Figuren 11 und 12) bzw. mehr oder weniger starke Strahlungs-Rückreflexion im Wellenleiter 26.

Bezugszeichenliste

- 1 Anordnung
- 2 Oberfläche
- 5 Stirnfläche
- 21 bis25 Sender
- 31 bis35 Empfänger
- 26 Wellenleiter
- 125; 225 Resonatoren
- 135; 235 Resonatoren
- 126 Gitterstruktur auf Wellenleiter
- 121, 221 Reflektor, Spiegel
- 321 Elektroden
- 421 Gitterstruktur
- 521 Grenzflächen

## Ansprüche

1. Integrierte optische Halbleiteranordnung **gekennzeichnet dadurch,**

-daß für die Verwendung als optischer Frequenzmultiplex-Sender und/oder -Empfänger mit Lasersender und/oder -verstärker

-ein einziges Substrat vorgesehen ist, das aus einem für Halbleiter-Laserdioden zu verwendenden Halbleitermaterial besteht und mit für Halbleiterlaser zu verwendender Schichtstruktur versehen ist,

-daß in der Schichtstruktur eine Anzahl optische Resonatorstrukturen mit wie für optoelektronische Bauelemente verwendeten Elektroden ausgebildet sind, wobei diese Strukturen eine jeweilige Longitudinalausrichtung haben,

-daß auf bzw. in der Schichtstruktur ein optischer Wellenleiter durch Ausbildung effektiven Brechungsindexunterschiedes in zur örtlichen Längsrichtung des Wellenleiters transversaler Richtung vorgesehen ist,

-daß die Resonatorstrukturen mit ihrer jeweiligen Longitudinalausrichtung parallel zur jeweiligen örtlichen Längsrichtung des Wellenleiters so dicht benachbart dem Wellenleiter angeordnet sind, daß eine gegenseitige laterale wellenoptische Kopplung zwischen Wellenleiter und jeweiliger Resonatorstruktur besteht.

2. Halbleiteranordnung nach Anspruch 1, **gekennzeichnet dadurch,**
daß wenigstens eine wesentliche Anzahl der optischen Resonatorstrukturen in der Ausführung mit Fabry-Perot-Resonator (Fig. 3, Fig. 5) realisiert ist.

3. Halbleiteranordnung nach Anspruch 1, **gekenn zeichnet, dadurch** daß wenigstens eine wesentliche Anzahl der optischen Resonatorstrukturen (21 bis 25, 31 bis 35) als DFB-Resonatorstruktur (Fig. 4, Fig. 7) realisiert ist.

4. Halbleiteranordnung nach Anspruch 1, **gekennzeichnet dadurch,** daß wenigstens eine wesentliche Anzahl der optischen Resonatorstrukturen (21 bis 25, 31 bis 35) als Kombination mit Fabry-Perot-Resonator und DFB-Resonator realisiert ist (Fig. 6).

5. Halbleiteranordnung nach Anspruch 1, **gekennzeichnet,** dadurch daß die optischen Resonatorstrukturen (21 bis 25, 31 bis 35) zu einem Anteil als Fabry-Perot-Resonatoren (Fig. 3, Fig. 5), als DFB-Resonatoren (Fig. 4, Fig. 7) und/oder als Kombination aus Fabry-Perot-Resonator und DFB-Resonator (Fig. 6) realisiert sind.

6. Halbleiteranordnung nach einem der Ansprüche 1 bis 5, **gekennzeichnet dadurch,** daß der Wellenleiter (26) an bezogen auf optische Resonatorstrukturen (21 bis 25, 31 bis 35) vorgegebenen Stellen mit einer Resonatorausführung (126) versehen ist (Fig. 8 bis 12).

7. Halbleiteranordnung nach einem der Ansprüche 1 bis 6, **gekennzeichnet dadurch,** daß eine (jeweilige) Resonatorstruktur (25, 35) aus mehreren parallel zueinander angeordneten, wellenoptisch miteinander verkoppelten Einzelresonatoren - (125, 225) gebildet ist.

8. Halbleiteranordnung nach Anspruch 7, **gekenn zeichnet dadurch,** daß eine solche Resonatorstruktur (35) als Empfänger als Kombination aus aktivem Filter (135) und selektiver Fotodiode - (235) betrieben ist.

FIG 1
II
II
5
$f_{L1}$
21
$f_{L2}$
22
$f_{L3}$
23
24
25
$f_{Ln}$
225
125
135
235
$f_{D1}$
31
$f_{D2}$
32
$f_{D3}$
33
34
35
$f_{Dm}$
26
27
$f_{L1,2,3..n}$
$f_{D1,2,3..m}$
FIG 2
22
26
32
2
1
FIG 3
321
121
221
21
FIG 4
321
121
221
421
FIG 5
321
121
221
21
521
21
FIG 6
321
121
221
421
521
FIG 7
321
121
221
421
521
421

FIG 8
21/31
26
126
FIG 9
21/31
26
126
FIG 10
21/31
26
126
FIG 11
21/31
26
126

FIG 12
21/31
26
126